# EUROPEAN PATENT APPLICATION

(11) **EP 4 553 817 A1**
(43) Date of publication of application: **14.05.2025**
(21) Application number: 24209421.7
(22) Date of filing: 29.10.2024
(51) Int. Cl.: G09G 3/20, G09G 3/32

(54) **TRANSPARENT DISPLAY**

(30) Priority: 08.11.2023 JP 2023190462
(71) Applicant: Alps Alpine Co., Ltd., Ota-ku, Tokyo 145-8501 (JP)
(72) Inventor: Okada, Hiroki, Iwaki-city, Fukushima (JP)
(74) Representative: Schmitt-Nilson Schraud Waibel Wohlfrom Patentanwälte Partnerschaft mbB

(57) **Abstract**

A transparent display includes a substrate formed of a transparent material and having a plurality of pixel regions which are partitioned, a plurality of micro-LEDs disposed in each of the plurality of pixel regions, each of the micro-LEDs being configured to emit light of a corresponding color of a plurality of colors, interconnects configured to apply a common drive voltage to the plurality of micro-LEDs included in pixel regions arranged in a same row among the plurality of pixel regions, and a driver configured to generate the common drive voltage and apply the common drive voltage to the interconnects, wherein the interconnects include a plurality of branch interconnects each configured to apply the common drive voltage separately to a corresponding micro-LED of the plurality of micro-LEDs included in a same pixel region of the plurality of pixel regions.

## Description

The present invention relates to transparent displays using micro-LEDs.

There are several methods to achieve a transparent display, and one of them is a method using micro-LEDs. Micro-LEDs are inorganic EL (Electro Luminescence) and have an advantage of excellent reliability.

In a transparent display, on a surface of each pixel on a substrate made of a transparent material, micro-LEDs of three RGB colors that are smaller than each pixel size (e.g., one side is 100 µm or less) are arranged. A total number of these LEDs is equivalent to three times the resolution, for example, two million in a case of full high vision (FHD), and the number of interconnects to drive each LED is also enormous.

Note that, in the case where each micro-LED is driven by a passive matrix method (e.g., see JP 2021-182613 A), each LED does not continue to emit light while each frame is displayed, but temporarily emits light during scanning. Therefore, in order to ensure sufficient luminance, it is necessary to increase a drive current If. For example, in the LED substrate disclosed in JP 2021-182613 A, a common anode interconnect a extending from an anode driver is connected to each anode of a plurality of LEDs arranged in a same row, and the drive current If is supplied to each LED arranged in a same row through the anode interconnect a.

Note that, in the LED substrate disclosed in the above-mentioned JP 2021-182613 A, when the drive current If flowing through the anode interconnect a commonly connected to the plurality of LEDs arranged in a same row is increased, a voltage drop due to interconnect impedance occurs, and the drive voltage Vf of each LED decreases. Therefore, it is necessary to reduce the interconnect impedance of the anode interconnect a. However, if a width of the anode interconnect a is simply increased, in the case of a transparent display, there is a problem that this interconnect becomes conspicuous as a single interconnect.

An object of the present invention is to provide a transparent display capable of reducing a drop in a drive voltage when a drive current is increased, and avoiding conspicuous interconnects for carrying the drive current.

The present disclosure relates to a transparent display according to the appended claims. Embodiments are disclosed in the dependent claims. According to an aspect, a transparent display includes a substrate formed of a transparent material and having a plurality of pixel regions which are partitioned, a plurality of micro-LEDs disposed in each of the plurality of pixel regions, each of the micro-LEDs being configured to emit light of a corresponding color of a plurality of colors, interconnects configured to apply a common drive voltage to the plurality of micro-LEDs included in pixel regions arranged in a same row among the plurality of pixel regions, and a driver configured to generate the common drive voltage and apply the common drive voltage to the interconnects, wherein the interconnects include a plurality of branch interconnects each configured to apply the common drive voltage separately to a corresponding micro-LED of the plurality of micro-LEDs included in a same pixel region of the plurality of pixel regions.

Since the drive current to be supplied to each micro-LED is distributed through a plurality of branch interconnects instead of being supplied to each micro-LED through a single line, the impedance across the plurality of branch interconnects can be reduced, and the reduction in the drive voltage caused by the voltage drop of the lines when the drive current is increased can be reduced. In addition, since each branch interconnect does not need to be made thick, it is possible to avoid conspicuous lines in a transparent display.

It is preferable that the plurality of branch interconnects are connected to the driver via a single interconnect. Thus, use of the same driver as in the related art is enabled.

It is preferable that the plurality of micro-LEDs are three micro-LEDs respectively emitting red light, green light, and blue light, and wherein the micro-LEDs of a same color included in the pixel regions arranged in a same row are connected to the same branch interconnect of the plurality of branch interconnects. Design is facilitated, and regular branch interconnects and arrangement of the respective micro-LEDs are enabled.

It is preferable that in each of the pixel regions, the plurality of branch interconnects are connected to each other via one or more connection interconnects. Thus, when there is a variation in the drive current flowing through the respective branch interconnects, the variation can be adjusted, and the overall impedance of the respective branch interconnects combined can be further reduced.
FIG. 1 is a drawing illustrating a structure of a transparent display according to an embodiment;
FIG. 2 is a drawing illustrating a portion of a substrate including micro-LEDs and interconnects in each pixel region according to an embodiment;
FIG. 3 is a timing diagram of a cathode voltage applied to each cathode interconnect according to an embodiment;
FIG. 4 is a drawing illustrating a portion of a substrate of a conventional transparent display; and
FIG. 5 is a drawing illustrating a portion of a substrate of a transparent display of a modification according to an embodiment.

In the following, a transparent display according to embodiments of the present invention will be described with reference to the accompanying drawings.

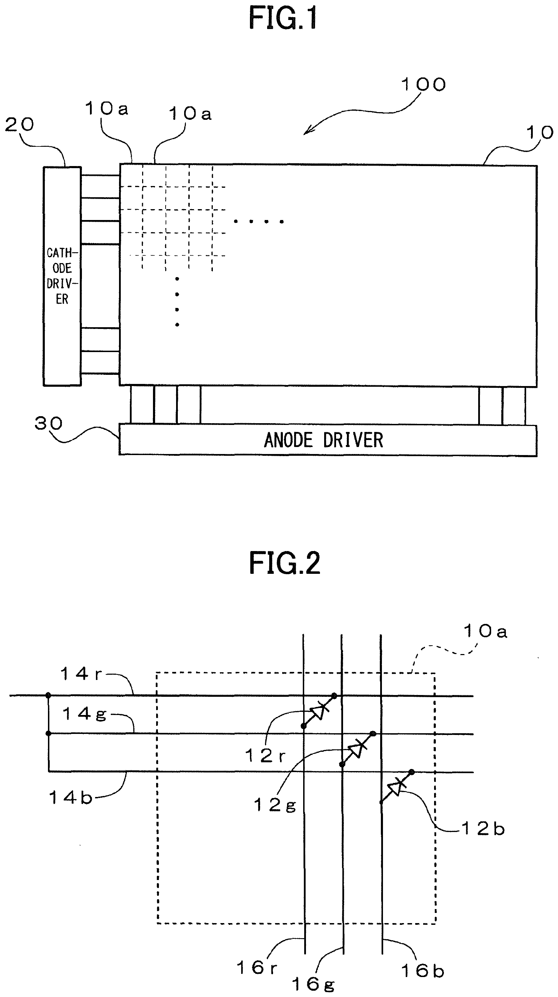

FIG. 1 is a drawing illustrating a structure of a transparent display according to an embodiment. The transparent display 100 shown in FIG. 1 includes a substrate 10 having a plurality of micro-LEDs arranged on its surface, a cathode driver 20 to generate a drive voltage to be applied to the cathode of each micro-LED, and an anode driver 30 to generate the drive voltage to be applied to the anode of each micro-LED.

The substrate 10 is made of a transparent glass material or a resin material, and the plurality of micro-LEDs and cathode interconnects and anode interconnects to apply the drive voltage to the respective micro-LEDs are arranged on its surface. The substrate 10 has a plurality of pixel regions 10a partitioned by the surface. These plurality of pixel regions 10a correspond to resolution of the transparent display 100, and each pixel region 10a corresponds to 1 pixel. Each pixel region 10a includes three micro-LEDs, each emitting light of different colors (specifically, three colors).

The cathode driver 20 generates a cathode voltage to be applied to the cathode of each micro-LED via the cathode interconnect. The anode driver 30 generates an anode voltage to be applied to the anode of each micro-LED via the anode interconnect.

FIG. 2 is a drawing illustrating a portion of the substrate 10 including the micro-LEDs and interconnects in each pixel region 10a. As shown in FIG. 2, the pixel region 10a as each pixel is set in the substrate 10, and each pixel region 10a includes three micro-LEDs 12r, 12g, and 12b that emit R (red), G (green), and B (blue) light, respectively. Since the micro-LEDs 12r, 12g, and 12b are smaller in size than the pixel region 10a of the substrate 10, a background is seen through the transparent pixel region 10a.

Each of the three micro-LEDs 12r, 12g, and 12b in each pixel region 10a is connected to its corresponding cathode interconnect from among cathode interconnects 14r, 14g, and 14b as a plurality of branch interconnects applying the same drive voltage separately. These three cathode interconnects 14r, 14g, and 14b extend along a scanning direction (horizontal direction in FIG. 1) of the transparent display 100 so as to pass through each of the pixel regions 10a arranged in the scanning direction, and are connected in the same matter to the three micro-LEDs 12r, 12g, and 12b respectively in each pixel region 10a. That is, one cathode interconnect 14r extending in the scanning direction is connected to the cathode of the micro-LED 12r in each pixel region 10a. One cathode interconnect 14g extending in the scanning direction is connected to the cathode of the micro-LED 12g in each pixel region 10a. One cathode interconnect 14b extending in the scanning direction is connected to the cathode of the micro-LED 12b in each pixel region 10a.

Further, these three cathode interconnects 14r, 14g, and 14b are connected outside the pixel region 10a at a position toward the cathode driver 20. For this reason, the cathode voltage having a common voltage is commonly applied from the cathode driver 20 to the cathodes of all the micro-LEDs 12r, 12g, and 12b in all the pixel regions 10a arranged along the scanning direction through these three cathode interconnects 14r, 14g, and 14b branched from one interconnect.

Separate anode interconnects 16r, 16g, and 16b extending from the anode driver 30 are connected to the anodes of the respective micro-LEDs 12r, 12g, and 12b, and the anode voltages indicating a gradation of the respective pixels corresponding to the display data are applied separately.

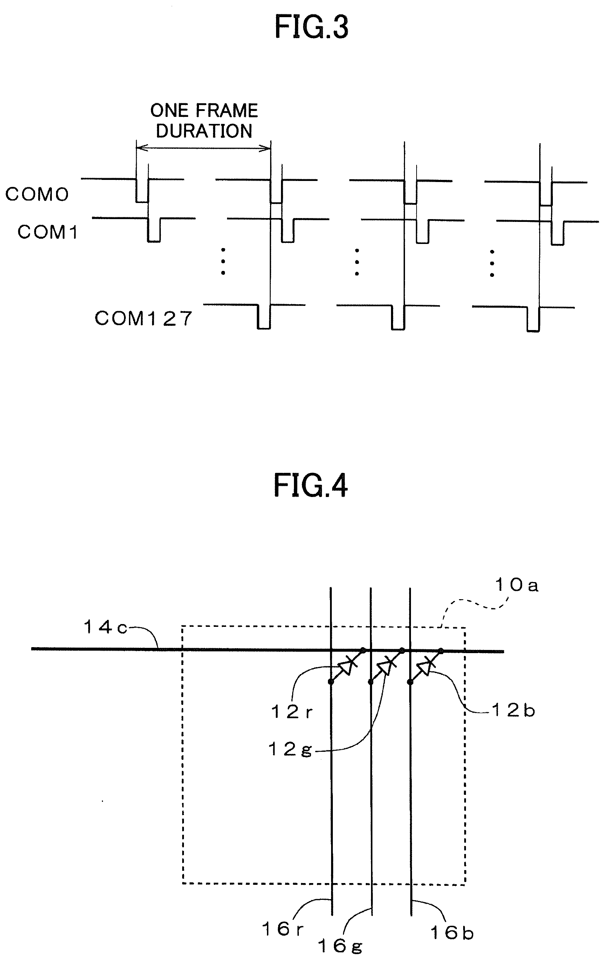

FIG. 3 is a timing diagram of the cathode voltage applied to each cathode interconnect. The transparent display 100 of this embodiment is driven by a passive matrix system, and a number of scanning lines (a number of pixels in a vertical direction) is 128, and 128 cathode voltages COM0 to COM127 whose effective timing is shifted within one frame are generated by the cathode driver 20.

The cathode voltage COM0 is applied to the cathodes of the micro-LEDs 12r, 12g, and 12b included in the plurality of pixel regions 10a arranged along an uppermost scanning line (L0) of the substrate 10, and the voltage level temporarily changes from H to L in accordance with the scanning timing of the scanning line LO. The cathode voltage is simultaneously applied to the cathodes of all the micro-LEDs 12r, 12g, and 12b included in the scanning line LO through the three cathode interconnects 14r, 14g, and 14b whose ends are connected. In parallel with the application of the cathode voltage, the anode voltage indicating the gradation of each pixel corresponding to the display data is applied from the anode driver 30 to the anodes of the micro-LEDs 12r, 12g, and 12b through the anode interconnects 16r, 16g, and 16b.

Similarly, the cathode voltage COM1 is applied to the cathodes of the micro-LEDs 12r, 12g, and 12b included in the plurality of pixel regions 10a arranged along a second scanning line (L1) from a top of the substrate 10, and the voltage level temporarily changes from H to L in accordance with the scanning timing of the scanning line L1. This cathode voltage is simultaneously applied to the cathodes of all the micro-LEDs 12r, 12g, and 12b included in the scanning line L0 via three cathode interconnects 14r, 14g, and 14b whose ends are connected. In parallel with the application of the cathode voltage, the anode voltage indicating the gradation of each pixel corresponding to the display data is applied from the anode driver 30 to the anodes of the micro-LEDs 12r, 12g, and 12b via the anode interconnects 16r, 16g, and 16b. The same is true for other scanning lines, and the cathode voltages COM2 to COM127 with staggered scanning timing are simultaneously applied from the cathode driver 20 to the cathodes of all the micro-LEDs 12r, 12g, and 12b included in each scanning line via the cathode interconnects 14r, 14g, and 14b.

FIG. 4 is a drawing illustrating a portion of a substrate of a conventional transparent display, and the same portions are shown for comparison with FIG. 2. As shown in FIG. 4, conventionally, the cathodes of the three micro-LEDs 12r, 12g, and 12b in the same pixel region 10a are connected to a common cathode interconnect 14c (anode interconnects extending in the scanning direction in JP 2021-182613 A), and the cathode voltages are simultaneously applied to the three micro-LEDs 12r, 12g, and 12b at the same timing, so that a wide cathode interconnect 14c is required to increase the drive current in order to increase luminance of each pixel. However, in this embodiment, since separate cathode interconnects 14r, 14g, and 14b are connected to the cathodes of the three micro-LEDs 12r, 12g, and 12b in the same pixel region 10a and the cathode voltage is applied thereto, it is possible to narrow the width of each of the cathode interconnects 14r, 14g, and 14b while maintaining the total drive current of the three micro-LEDs 12r, 12g, and 12b.

As described above, in the transparent display 100 of the present embodiment, the drive current supplied to the micro-LEDs 12r, 12g, and 12b is not supplied through a single interconnect, but the drive current supplied to the micro-LEDs 12r, 12g, and 12b is distributed through the plurality of cathode interconnects 14r, 14g, and 14b as branch interconnects, so that the impedance of the entirety of the plurality of cathode interconnects 14r, 14g, and 14b can be reduced, and the reduction of the drive voltage caused by the voltage drop of the interconnects when the drive current is increased can be reduced. Further, since it is not necessary to make the cathode interconnects 14r, 14g, and 14b thick, conspicuousness of the interconnect in the transparent display 100 can be avoided.

Further, since the ends of the three cathode interconnects 14r, 14g, and 14b are connected together and connected to the cathode driver 20, it is possible to use the same cathode driver 20 as in the conventional case where one cathode interconnects 14c (FIG. 4) are used.

In addition, since the three micro-LEDs 12r, 12g, and 12b emitting corresponding RGB light are used, and the micro-LEDs of the same color included in the pixel regions 10a arranged in a same row are connected to the same cathode interconnect from among the same cathode interconnects 14r, 14g, and 14b, it is possible to arrange the cathode interconnects 14r, 14g, and 14b and the micro-LEDs 12r, 12g, and 12b in a regular manner, thereby facilitating design.

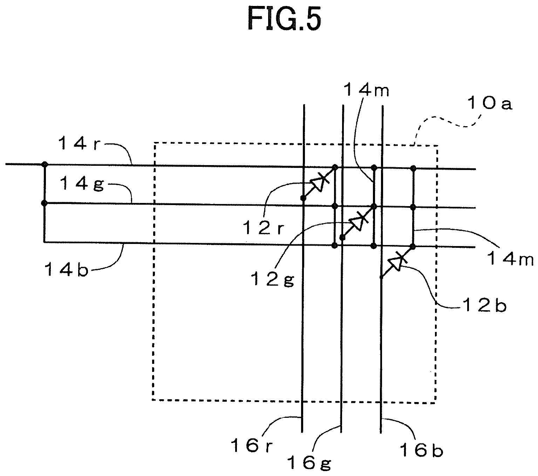

FIG. 5 is a drawing illustrating a portion of a substrate of a transparent display of a modification. A configuration shown in FIG. 5 is different from the configuration shown in FIG. 2 in that connection interconnects 14m for mutually connecting the three cathode interconnects 14r, 14g, and 14b passing through the pixel regions 10a are added.

Although drive currents flow simultaneously to the three micro-LEDs 12r, 12g, and 12b in the same pixel region 10a, their values are not the same according to the luminance of a corresponding RGB color. For this reason, strictly speaking, a slight variation occurs in the voltage drop in each of the cathode interconnects 14r, 14g, and 14b when the drive current is supplied through the separate cathode interconnects 14r, 14g, and 14b, but this variation can be eliminated by adding the connection interconnects 14m shown in FIG. 5, and the impedance of the entire cathode interconnects 14r, 14g, and 14b combined can be further reduced.

The present invention is not limited to the above-described embodiments, and various modifications can be made within the scope of the claims. Although the above-described embodiments have described the case where the cathode interconnects 14r, 14g, and 14b extend in the scanning direction, the present invention can also be applied to the case where the anode interconnects extend in the scanning direction as in JP 2021-182613 A.

Further, in the above-described embodiments, it is assumed that one cathode interconnect is distributed, among the three cathode interconnects 14r, 14g, and 14b, for each of the three micro-LEDs 12r, 12g, and 12b arranged in the horizontal direction in the pixel region 10a as shown in FIG. 4, but since the freedom of arrangement of the three micro-LEDs 12r, 12g, and 12b in the pixel region 10a is increased by separating the three cathode interconnects 14r, 14g, and 14b, the three micro-LEDs 12r, 12g, and 12b may be arranged in the vertical direction or another arrangement may be adopted.

As described above, according to aspects of the present invention, as the drive current to be supplied to each micro-LED is distributed through a plurality of branch interconnects instead of being supplied to each micro-LED through a single interconnect, the impedance across the plurality of branch interconnects can be reduced, and the reduction in the drive voltage caused by the voltage drop of the interconnect when the drive current is increased can be reduced. Further, since it is not necessary to make each branch interconnects thick, conspicuous interconnects in a transparent display can be avoided.

## Claims

1. A transparent display comprising:
a substrate formed of a transparent material and having a plurality of pixel regions which are partitioned;
a plurality of micro-LEDs disposed in each of the plurality of pixel regions, each of the micro-LEDs being configured to emit light of a corresponding color of a plurality of colors;
interconnects configured to apply a common drive voltage to the plurality of micro-LEDs included in pixel regions arranged in a same row among the plurality of pixel regions; and
a driver configured to generate the common drive voltage and apply the common drive voltage to the interconnects,
wherein the interconnects include a plurality of branch interconnects each configured to apply the common drive voltage separately to a corresponding micro-LED of the plurality of micro-LEDs included in a same pixel region of the plurality of pixel regions.

2. The transparent display according to claim 1, wherein the plurality of branch interconnects are connected to the driver via a single interconnect.

3. The transparent display according to claim 1 or 2,
wherein the plurality of micro-LEDs are three micro-LEDs respectively emitting red light, green light, and blue light, and
wherein the micro-LEDs of a same color included in the pixel regions arranged in a same row are connected to the same branch interconnect of the plurality of branch interconnects.

4. The transparent display according to one of claims 1 to 3, wherein, in each of the pixel regions, the plurality of branch interconnects are connected to each other via one or more connection interconnects.
